# EUROPÄISCHE PATENTSCHRIFT

(11) **EP 2 301 088 B1**
(45) Veröffentlichungstag und Bekanntmachung des Hinweises auf die Patenterteilung: **05.06.2013**
(21) Anmeldenummer: 10726043.2
(22) Anmeldetag: 08.06.2010
(51) Int. Cl.: H01L 35/32, H01L 35/34

(54) **MODUL MIT MEHREREN THERMOELEKTRISCHEN ELEMENTEN**
MODULE HAVING A PLURALITY OF THERMOELECTRIC ELEMENTS
MODULE DOTÉ DE PLUSIEURS ÉLÉMENTS THERMOÉLECTRIQUES

(30) Priorität: 10.07.2009 DE 102009032906
(43) Veröffentlichungstag der Anmeldung: 30.03.2011
(73) Patentinhaber: O-Flexx Technologies GmbH, 47059 Duisburg (DE)
(72) Erfinder: TEUNISSEN, Ralph, NL-7425 NR Deventer (NL); ULLAND, Holger, Albert, 47877 Willich (DE)
(74) Vertreter: Kohlmann, Kai
(86) Internationale Anmeldenummer: PCT/EP2010/057956
(87) Internationale Veröffentlichungsnummer: WO 2011/003685

(56) Entgegenhaltungen:
- EP-A2- 0 369 670
- EP-B1- 1 287 566
- JP-A- 1 208 876
- US-A1- 2008 289 677

## Beschreibung

Die Erfindung betrifft ein Modul umfassend mehrere elektrisch in Serie geschaltete thermoelektrische Elemente, die jeweils aus mindestens einer n-Schicht und mindestens einer p-Schicht aus thermoelektrischem Material unter Ausbildung wenigstens eines sich entlang einer Grenzschicht ausbildenden pn-Übergangs bestehen, wobei ein Temperaturgradient parallel zur Grenzschicht zwischen einer heißen und einer kalten Seite jedes thermoelektrischen Elementes anlegbar bzw. abgreifbar ist.

Die Wirkungsweise thermoelektrischer Elemente beruht auf dem thermoelektrischen Effekt, nachfolgend als Seebeck-Effekt bezeichnet. Beim Seebeck-Effekt entsteht zwischen zwei Punkten eines elektrischen Leiters bzw. zwei unterschiedlich dotierten Halbleitern, die eine verschiedene Temperatur haben, eine elektrische Spannung.

Die direkte Wandlung von Wärme in elektrische Energie ist mit einem thermoelektrischen Generator mit mehreren thermoelektrischen Elementen möglich. Die thermoelektrischen Elemente bestehen vorzugsweise aus unterschiedlich dotierten Halbleitermaterialien, wodurch sich die Effizienz gegenüber Thermoelementen mit zwei unterschiedlichen und an einem Ende miteinander verbundenen Metallen, wesentlich steigern lässt. Gebräuchliche Halbleitermaterialien sind Bi2Te3, PbTe, SiGe, BiSb oder FeSi2. Um ausreichend hohe Spannungen zu erhalten, werden mehrere thermoelektrische Elemente zu einem Modul zusammengefasst und elektrisch in Reihe geschaltet.

Um den Wirkungsgrad eines thermoelektrischen Generators zu steigern, wird in der EP 1 287 566 B1, ein gattungsgemäßes Modul umfassend mehrere elektrisch in Serie geschaltete thermoelektrische Elemente beschrieben. Die einzelnen thermoelektrischen Elemente bestehen jeweils aus mindestens einer n-Schicht und mindestens einer p-Schicht aus thermoelektrischem Material unter Ausbildung wenigstens eines sich entlang einer Grenzschicht ausbildenden pn-Übergangs. Parallel zur Grenzschicht zwischen den n- und p-Schichten ist ein Temperaturgradient angelegt. Der pn-Übergang ist im Wesentlichen entlang der gesamten, vorzugsweise längsten Ausdehnung der n-Schicht und der p-Schicht und damit im Wesentlichen entlang deren gesamter Grenzschicht ausgebildet. Durch den Temperaturgradienten entlang der großflächigen pn-Grenzfläche entsteht ein Temperaturunterschied entlang dieses länglich ausgebildeten pn-Übergangs zwischen zwei Enden eines pn-Schichtpakets, der dazu führt, dass der Wirkungsgrad des thermoelektrischen Elementes höher ist als beim Stand der Technik, der keinen Temperaturgradienten entlang und innerhalb des pn-Übergangs aufweist.

Ferner ist aus der JP 1 208876 A ein thermoelektrisches Modul mit thermoelektrischen Elementen mit mindestens einer n-Schicht und theremoelektrischen Elementen mit mindestens einer p-Schicht eines Halbleiters und einem Substrat bekannt, welches elektrische leitfähige Bereiche aufweist, die durch isolierende Bereiche voneinander getrennt sind.

Ausgehend von einem aus der EP 1 287 566 B1 bekannten Modul liegt der Erfindung die Aufgabe zu Grunde, ein produktionstechnisch vorteilhaftes Modul vorzuschlagen, bei dem die Widerstände der elektrischen Kontaktierung der einzelnen thermoelektrischen Elemente reduziert und deren thermische Anbindung an eine Wärmesenke bzw. Wärmequelle zur Erzeugung eines Temperaturgradienten entlang der Grenzschicht verbessert wird.

Diese Aufgabe wird bei einem Modul der eingangs erwähnten Art dadurch gelöst, dass das Modul ein Substrat mit mehreren elektrisch und thermisch leitfähigen Bereichen aufweist, die isolierende Bereiche thermisch und elektrisch voneinander trennen, jedes thermoelektrische Element eine nach außen weisende p-Schicht und eine an der gegenüberliegenden Seite nach außen weisende n-Schicht aufweist, eine nach außen weisende p-Schicht eines thermoelektrischen Elementes stets mit nur einer nach außen weisenden n-Schicht eines benachbarten thermoelektrischen Elementes elektrisch leitend verbunden ist und jeweils zwei benachbarte thermoelektrische Elemente an deren kalter Seite mittels einer thermisch und elektrisch leitenden Haftschicht mit einem der elektrisch und thermisch leitfähigen Bereiche des Substrats elektrisch leitend verbunden sind.

Ein wesentlicher Vorteil bei der Herstellung des erfindungsgemäßen Moduls besteht darin, dass die thermoelektrischen Elemente unabhängig von dem Substrat hergestellt werden können, bevor sie mit einem der elektrisch und thermisch leitfähigen Bereiche des Substrats verbunden werden.

Die separate Herstellung von Substrat und thermoelektrischen Elementen ermöglicht die massenhafte Produktion erfindungsgemäßer Module in einem von Rolle zu Rolle geführten Prozess. Die thermoelektrischen Elemente werden insbesondere durch chemische Gasphasenabscheidungen (CVD-Depositionsverfahren) der unterschiedlichen n- bzw. p-dotierten thermoelektrischen Materialien (Halbleitermaterialien) hergestellt. Alternativ werden die thermoelektrischen Elemente im Wege der physikalischen Gasphasenabscheidung (PVD-Depostionsverfahren) hergestellt. Im Gegensatz zum CVD-Verfahren werden die abgeschiedenen Dünnschichten direkt durch Kondensation eines Materialdampfes des thermoelektrischen Materials gebildet.

Das Substrat wird insbesondere durch Lamination eines folienartigen, insbesondere bahnförmigen Trägermaterials mit einer Schicht aus elektrisch und thermisch leitfähigem Material, beispielsweise einer Kupferfolie, hergestellt. Die Kupferfolie wird anschließend strukturiert. Die Strukturierung erfolgt durch teilweises Entfernen der Kupferfolie, so dass auf dem isolierenden Trägermaterial die elektrisch und thermisch leitfähigen Bereiche entstehen, die durch das isolierende Trägermaterial thermisch und elektrisch voneinander getrennt sind. Bei dem Trägermaterial handelt es sich insbesondere um einen Kunststoff aus der Gruppe PI (Polyimid), PA (Polyamid) oder PET (Polyethylenterephthalat).

Die elektrische Serienschaltung der thermoelektrischen Elemente wird bei dem erfindungsgemäßen Modul dadurch erreicht, dass die nach außen weisende p-Schicht eines thermoelektrischen Elementes stets mit nur einer nach außen weisenden n-Schicht eines benachbarten thermoelektrischen Elementes elektrisch leitend verbunden ist, wobei die elektrische Kontaktierung mittels der elektrisch und thermisch leitfähigen Bereiche auf dem Substrat stets nur zu einem weiteren thermoelektrischen Element erfolgt. Die weitere notwendige elektrische Kontaktierung benachbarter thermoelektrischer Elemente, die mit voneinander getrennten elektrisch und thermisch leitfähigen Bereichen des Substrats verbunden sind, erfolgt an deren dem Substrat abgewandten, nach außen weisenden p- bzw. n-Schicht mittels eines elektrischen Leiters. Der Leiter kann mit den elektrisch zu verbindenden Schichten verklebt oder verlötet sein. Er kann als Draht, Bändchen oder Folie ausgestaltet sein.

Die sichere Fixierung sowie gute thermische und elektrische Anbindung der thermoelektrischen Elemente an das Substrat auf der kalten Seite wird durch die thermisch und elektrisch leitende Haftschicht bewirkt. Diese Haftschicht kann beispielsweise aus einem Einkomponenten-Epoxykleber bestehen, der mit leitenden Metallpartikeln gefüllt ist, oder als ein beidseitig haftender Klebefilm mit leitenden Metallpartikeln in einer Epoxyharzmatrix ausgeführt werden.

Die benachbarten thermoelektrischen Elemente sind an deren heißer Seite mittels einer thermisch leitenden und elektrisch isolierenden Haftschicht mit einem vorzugsweise durchgängigen elektrisch und thermisch leitfähigen Bereich auf dem Substrat verbunden. Diese Haftschicht kann beispielsweise aus einem Einkomponenten-Epoxykleber bestehen oder als ein beidseitig haftender Klebefilm ausgeführt werden. Hierdurch wird bewirkt, dass die elektrische Kontaktierung der thermoelektrischen Elemente nur auf der kalten Seite der thermoelektrischen Elemente erfolgt. Ein Großteil des Wärmestroms zwischen der Wärmequelle auf der heißen Seite und der Wärmesenke auf der kalten Seite fließt über die thermoelektrischen Elemente und wandelt dabei die Wärme in elektrische Energie um.

Die elektrisch und thermisch leitfähigen Bereiche auf dem vorzugsweise flexiblen, bahnförmigen Trägermaterial des Substrats sind vorzugsweise durch einen längs und mehrere quer zu der Längsachse des bahnförmigen Trägermaterials verlaufende, isolierende Stege elektrisch voneinander getrennt. An der heißen Seite der thermoelektrischen Elemente wird einseitig des längs verlaufenden isolierenden Steges vorzugsweise lediglich ein elektrisch und thermisch leitfähiger Bereich ausgebildet, der mit der Wärmequelle verbindbar ist. Dieser unterbrechungsfreie Bereich lässt eine gleichmäßige Einkopplung der Wärme in die thermisch parallel geschalteten thermoelektrischen Elemente zu. Des Weiteren sind Strukturierungsprozesse des leitfähigen Bereichs in diesem Bereich entbehrlich, so dass die Produktion des Moduls weiter vereinfacht wird.

An der kalten Seite der thermoelektrischen Elemente wird einseitig des längs verlaufenden isolierenden Steges das thermisch und elektrisch leitfähige Material fortlaufend, vorzugsweise in regelmäßigem Abständen, in mehrere thermisch und elektrisch leitfähige Bereiche durch quer zu dem bahnförmigen Trägermaterial verlaufende isolierende Stege unterteilt. Der Abstand der isolierenden Stege wird so gewählt, dass jeweils zwei benachbarte thermoelektrische Elemente mittels der thermisch und elektrisch leitenden Haftschicht mit einem der elektrisch und thermisch leitfähigen Bereiche auf der kalten Seite kontaktiert werden können.

Um die Wärme in die heiße Seite des thermoelektrischen Elementes effektiv einzukoppeln und die Wärme auf der kalten Seite effektiv abzuführen, weist das erfindungsgemäße Modul vorzugsweise eine Wärmesenke und eine Wärmequelle auf. Die Wärmesenke ist beispielsweise ein Kühlkörper. Die Wärmequelle ist beispielsweise als Wärmetauscher ausgeführt, der die Abwärme eines anderen Prozesses in das Modul einkoppelt. Um die Übertragung der Wärme zwischen dem Modul einerseits und der Wärmequelle bzw. Wärmesenke andererseits zu verbessern, überdecken die nach außen weisenden p- bzw. n-Schichten der thermoelektrischen Elemente die elektrisch und thermisch leitfähigen Bereiche des Substrates nur teilweise. Der nicht überdeckte Bereich kann dann vollflächig mit der Wärmesenke bzw. Wärmequelle in Kontakt gebracht werden.

Die thermoelektrischen Elemente umfassen vorzugsweise mehr als zwei abwechselnd angeordnete n- und p-Schichten, um den Temperaturgradienten effektiver in elektrischen Strom umzuwandeln. Um eine gute thermische Anbindung sämtlicher Schichten eines derartigen Schichtstapels zu gewährleisten und zugleich zwei benachbarte thermoelektrische Elemente, die mit voneinander getrennten elektrisch und thermisch leitfähigen Bereichen des Substrats verbunden sind, elektrisch miteinander zu koppeln, sind deren dem Substrat abgewandten, nach außen weisenden p- bzw. n-Schichten mittels elektrisch leitender Bereiche eines weiteren Verbindungssubstrats miteinander verbunden.

Ein vorteilhaftes Verfahren zum Herstellen eines erfindungsgemäßen Moduls umfasst folgende Schritte:
- Herstellen eines Substrates durch Aufbringen einer elektrisch und thermisch leitfähigen Schicht auf einem Trägermaterial aus thermisch und elektrisch isolierendem Material und
- bereichsweises Entfernen der elektrisch und thermisch leitfähigen Schicht zur Ausbildung elektrisch und thermisch leitfähiger Bereiche auf dem Trägermaterial.
- Aufbringen einer thermisch und elektrisch leitenden Haftschicht auf der kalten Seite von unabhängig vom Substrat hergestellten thermoelektrischen Elementen sowie oder vorzugsweise Aufbringen einer thermisch und elektrisch leitenden Haftschicht auf der kalten Seite des Substrats. Die Haftschicht muss auf den thermisch und elektrisch leitfähigen Bereichen des Substrats zumindest im Kontaktbereich der thermoelektrischen Elemente auf der kalten Seite aufgebracht werden.
- Aufbringen einer thermisch leitenden und elektrisch isolierenden Haftschicht auf der heißen Seite jedes thermoelektrischen Elementes oder vorzugsweise Aufbringen einer thermisch leitenden und elektrisch isolierenden Haftschicht auf der heißen Seite des Substrats. Die Haftschicht muss auf jedem thermisch und elektrisch leitfähigen Bereich des Substrats zumindest im Kontaktbereich der thermoelektrischen Elemente auf der heißen Seite aufgebracht werden.
- Verbinden von jeweils zwei thermoelektrischen Elementen mit ihren nach außen weisenden p- bzw. n-Schichten an deren kalter Seite mit einem der elektrisch und thermisch leitfähigen Bereiche des Substrats sowie
- Verbinden der thermoelektrischen Elemente mit mindestens einem der elektrisch und thermisch leitfähigen Bereiche des Substrats an der heißen Seite.
- Herstellen einer elektrischen Verbindung zwischen zwei benachbarten thermoelektrischen Elementen, die mit voneinander getrennten elektrisch und thermisch leitfähigen Bereichen des Substrats elektrisch leitend verbunden sind, an deren dem Substrat abgewandten nach außen weisenden p- bzw. n-Schichten.

Nachfolgend wird die Erfindung anhand der Ausführungsbeispiele näher erläutert. Es zeigen:

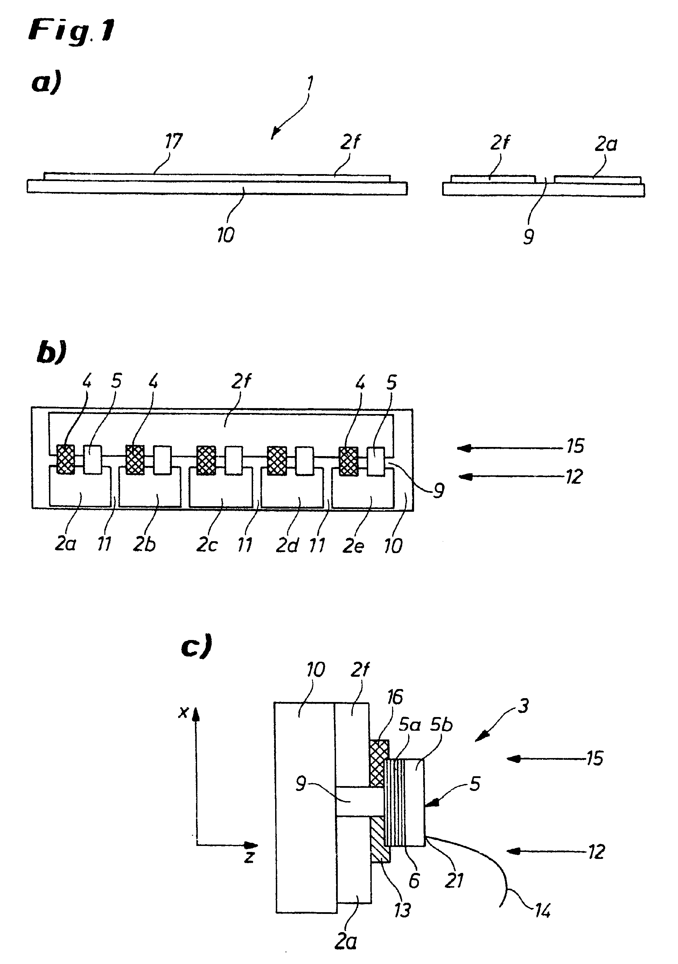

- **Figur 1 a**: eine Seitenansicht eines bahnförmigen flexiblen Substrats eines erfindungsgemäßen Moduls,
- **Figur 1 b**: ein teilweises fertig gestelltes erfindungsgemäßes Modul in Aufsicht,
- **Figur 1 c**: eine Seitenansicht eines fertig gestellten erfindungsgemäßen Moduls,
- **Figur 2**: eine Seitenansicht des Moduls nach Figur 1 b mit Darstellung des Stromflusses,
- **Figur 3 a**: eine Seitenansicht eines Moduls entsprechend Figur 1 c zur Veranschaulichung des Wärmeflusses,

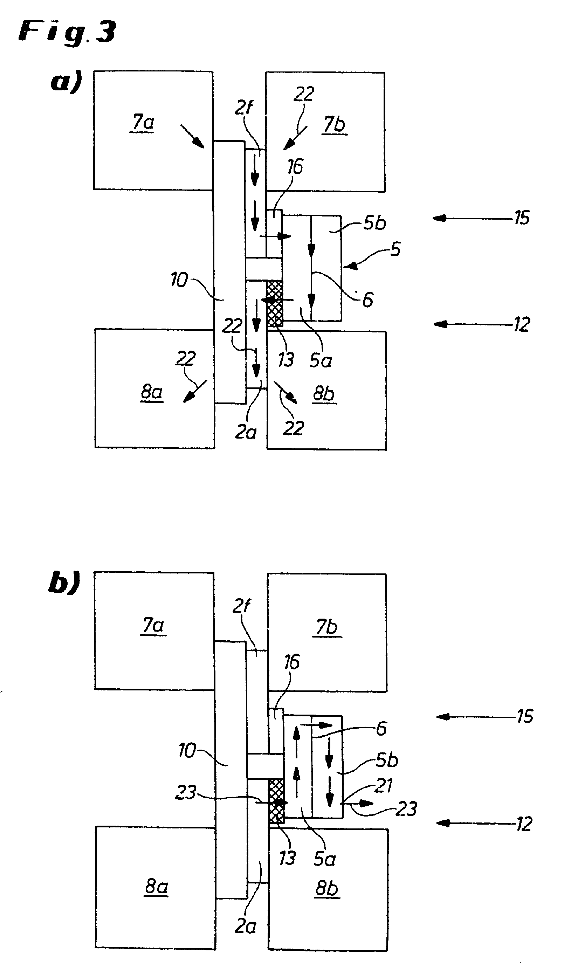

- **Figur 3 b**: eine Seitenansicht eines Moduls entsprechend Figur 1 c zur Veranschaulichung des Stromflusses,

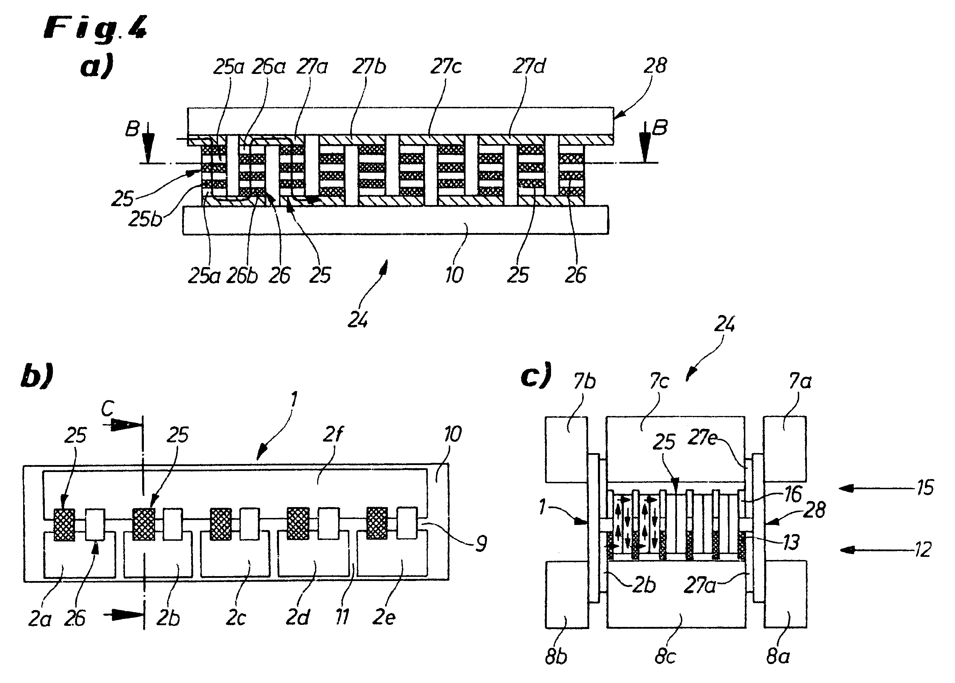

- **Figur 4**: ein zweites Ausführungsbeispiel eines erfindungsgemäßen Moduls mit thermoelektrischen Elementen, die aus einer Vielzahl von abwechselnd angeordneten n- und p-Schichten zusammengesetzt sind, wobei
- **Figur 4 a**: das Modul in Seitenansicht,
- **Figur 4 b**: einen Schnitt durch das Modul nach Figur 4 a längst der Linie B-B und
- **Figur 4c**: einen Schnitt durch das Modul längs der Linie C-C in Figur 4 b zeigt,

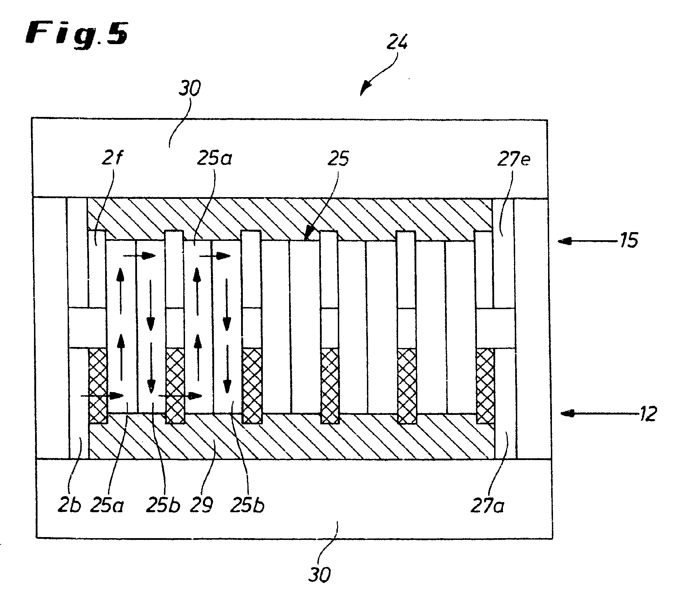

- **Figur 5**: ein Modul entsprechend Figur 4, jedoch in einem geschlossenen Gehäuse.

Das erfindungsgemäße Modul (3) besteht im Wesentlichen aus einem Substrat (1) mit mehreren elektrisch und thermisch leitfähigen Bereichen (2 a - e) sowie einem elektrisch und thermisch leitfähigen Bereich (2 f) auf einem Trägermaterial (10). Die elektrisch und thermisch leitfähigen Bereiche werden durch einen längs verlaufenden isolierenden Steg (9) und mehrere quer zu dem Steg (9) verlaufende Stege (11) elektrisch voneinander getrennt. Des Weiteren umfasst das Modul (3) eine Vielzahl elektrisch in Serie geschalteter thermoelektrischer Elemente (4, 5), die jeweils aus mindestens einer n-Schicht (4 a, 5 a) und mindestens einer p-Schicht (4 b, 5 b) aus thermoelektrischem Material bestehen.

Das Trägermaterial (10) ist eine Folie aus PI, PA oder PET. Die leitfähigen Bereiche (2 a- f) bestehen aus Kupfer. Die n-bzw. p-Schicht (4a, 5a, 4b, 5b) jedes thermoelektrischen Elementes (4,5) wird aus n- bzw. p-dotiertem Halbleitermaterial mit guten thermoelektrischen Eigenschaften gebildet.

Wie insbesondere aus Figur 1 c erkennbar, berühren sich die abwechselnd angeordneten n- bzw. p-Schichten (4a, 5a, 5a, 5b) jedes thermoelektrischen Elementes (4, 5) vollflächig entlang einer Grenzschicht (6). Parallel zu der Grenzschicht (6) (in x-Richtung) wird ein Temperaturgradient zwischen einer Wärmequelle (7 a, b) und einer Wärmesenke (8 a, b) angelegt (vgl. auch Figur 3).

Jedem der elektrisch und thermisch leitfähigen Bereiche (2 a - e) sind jeweils genau zwei thermoelektrische Elemente (4, 5) zugeordnet, wobei eines der thermoelektrischen Elemente mit der n-Schicht (5 a, 4 a) und das andere thermoelektrische Element mit der p-Schicht (5 b, 4 b) in Richtung des Substrats (1) orientiert sind.

Jeweils zwei benachbarte thermoelektrische Elemente (4, 5) sind an deren kalter Seite (12) mittels einer Haftschicht (13) mit einem der Bereiche (2 a - e) des Substrats (1) elektrisch und thermisch leitend verbunden. Die Verbindung benachbarter thermoelektrischer Elemente (4, 5), die mit voneinander getrennten elektrisch und thermisch leitfähigen Bereichen (2 a - 2 e) verbunden sind, werden ebenfalls auf der kalten Seite (12) an der gegenüberliegenden, das heißt dem Substrat (1) abgewandten, nach außen weisenden p-Schicht (4 b, 5b) bzw. n-Schicht (4a, 5 a) mittels eines elektrischen Leiters (14) in Form einer Drahtverbindung elektrisch leitend verbunden.

Sämtliche thermoelektrischen Elemente (4, 5) sind an deren heißer Seite (15) mittels einer ausschließlich thermisch leitenden Haftschicht (16), insbesondere einem thermisch leitfähigen Klebstoff, mit dem durchgehenden, sich in Längsrichtung des Substrats (1) erstreckenden leitfähigen Bereich (2 f) verbunden.

Wie insbesondere aus der Aufsicht in Figur 1 b erkennbar, werden sämtliche Bereiche (2 a - f) von den thermoelektrischen Elementen (4, 5) nur teilweise überdeckt. Der zum Rand des Substrats (1) weisende, nicht überdeckte Abschnitt des Bereichs (2 f) wird thermisch leitend zwischen den beiden Bestandteilen der Wärmquelle (7 a, b) eingeklemmt. Auf der kalten Seite (12) wird dieser freie Abschnitt der leitfähigen Bereiche (2 a - e) thermisch leitend zwischen den beiden Bestandteilen der Wärmesenke (8 a, b) eingeklemmt.

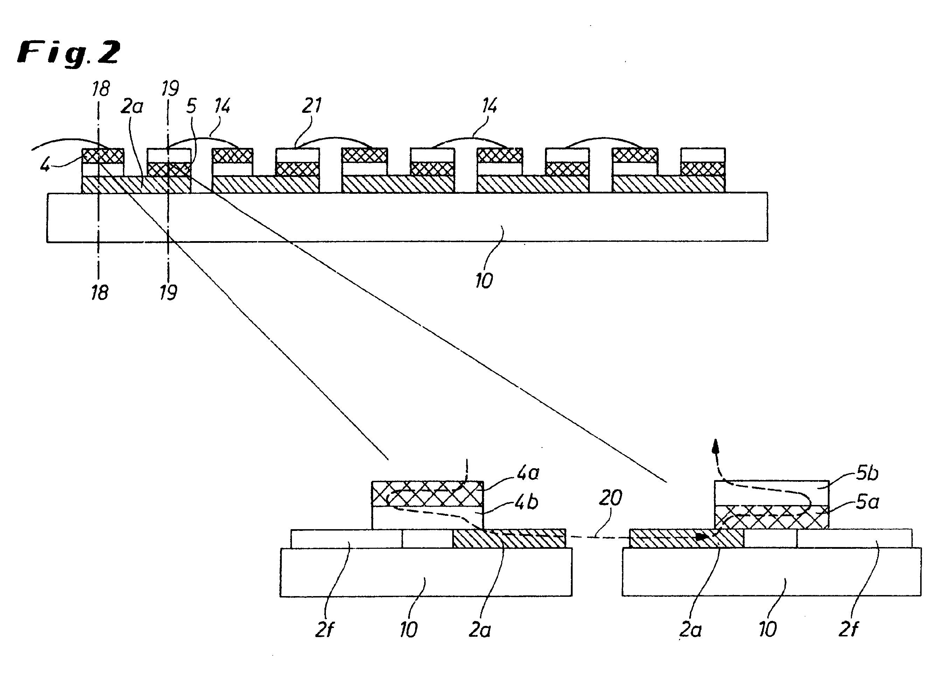

Figur 2 verdeutlicht anhand der Schnittdarstellung längs der Schnittlinien (18, 19) durch das Modul (3) den Verlauf des Stromflusses (20), der sich in Folge des Temperaturgradienten in zwei benachbarten thermoelektrischen Elementen (4, 5) abhängig von der Dotierung der Halbleiter (4 a, 4 b bzw. 5 a, 5b) einstellt.

Figur 3 a verdeutlich den Wärmefluss (22) durch das thermoelektrische Element (5) (vgl. Schnittlinie (19) nach Figur 2). Von der Wärmequelle (7 a, 7 b) gelangt der Wärmefluss (22) in den aus Kupfer bestehenden, thermisch leitfähigen Bereich (2 f), über die thermisch leitende Haftschicht (16) in die heiße Seite (15) des thermoelektrischen Elementes (5). Von dort gelangt der Wärmefluss (22) über die thermisch und elektrisch leitende Haftschicht (13) sowie den darunter angeordneten thermisch und elektrisch leitenden Bereich (2 a) zu der Wärmesenke (8 a, b) auf der kalten Seite (12) des thermoelektrischen Elementes.

Figur 3 b veranschaulicht an demselben thermoelektrischen Element (5) den von der kalten Seite (12) ausgehenden Stromfluss (23) durch das thermoelektrische Element (5). Von dem thermisch und elektrisch leitenden Bereich (2 a) gelangt der Strom über die thermisch und elektrisch leitende Haftschicht (13) in die n-Schicht (5 a) in Richtung der heißen Seite (15). Über die Grenzschicht (6) fließt der Strom zurück in Richtung der kalten Seite (12) des thermoelektrischen Elementes (5) zu der Kontaktierung (21) für den elektrischen Leiter (14) zu dem benachbarten, durch einen Steg (9) getrennten thermoelektrischen Element (4).

Das Modul (24) nach Figur 4 unterscheidet sich von dem Modul (3) nach den Figuren 1 - 3 im Wesentlichen durch den Aufbau der thermoelektrischen Elemente (25, 26). Abweichend zu den thermoelektrischen Elementen (4, 5) bestehen diese nicht lediglich aus einer n- und einer p-Schicht, sondern einem Schichtstapel in dem alternierend n- und p-Schichten (25 a, b und 26 a, b) angeordnet sind. Die thermisch und elektrisch leitenden Bereiche (2 a - e) sowie der durchgehende Bereich (2 f) sind auf dem Trägermaterial (10) in gleicher Weise angeordnet.

Abweichend zu dem Ausführungsbeispiel nach den Figuren 1 - 3 sind jeweils zwei benachbarte thermoelektrische Elemente (25, 26), die mit voneinander getrennten elektrischen und thermisch leitfähigen Bereichen (2 a -e) des Substrats (1) verbunden sind, an ihrer dem Substrat (1) abgewandten, nach außen weisenden p-Schicht (25 a, 26 b) bzw. n-Schicht (25 a, 26 a) mittels elektrisch leitender Bereiche (27 a - d) eines Verbindungssubstrates (28) elektrisch untereinander verbunden. Das Verbindungssubstrat (28) kann in gleicher Weise wie das Substrat (1) aufgebaut und hergestellt werden. Insbesondere ist es vorteilhaft, wenn die elektrisch leitenden Bereiche (27 a - d) auch gut thermisch leitend ausgeführt sind, beispielsweise indem diese aus Kupfer bestehen.

Das Verbindungssubstrat (28) weist einen weiteren elektrisch leitenden Bereich (27 e) auf, der ausschließlich thermisch leitend mit den thermoelektrischen Elementen (25, 26) an der heißen Seite (15) verbunden ist. Für die Verbindung werden auch hier thermisch und elektrisch leitende Haftschichten (13) auf der kalten Seite und ausschließlich thermisch leitende Haftschichten (16) auf der heißen Seite (15) verwandt.

Sowohl die Wärmesenke (8) als auch die Wärmequelle (7) weisen im Ausführungsbeispiel des Moduls (24) nach Figur 4 ein drittes Teil (7 c) bzw. (8 c) auf, das zwischen den Substraten (1 und 28) längs der kalten (12) bzw. der heißen Seite (15) der thermoelektrischen Elemente (25, 26) der thermoelektrischen Elemente angeordnet ist.

Figur 5 Zeigt ein Modul (24) entsprechend Figur 4 bei dem die Wärmesenke und die Wärmequelle durch eine thermisch leitende, jedoch elektrisch isolierende Vergussmasse (29) gebildet werden, die an der kalten Seite (12) jedes thermoelektrischen Elementes (25, 26) einerseits und an der heißen Seite (15) jedes thermoelektrischen Elementes (25, 26) andererseits sowie den elektrisch und thermisch leitenden Bereiche (2 a-f, 27 a - e) anliegt Zur mechanischen Stabilisierung kann das Modul (24) in einem Gehäuse (30) angeordnet sein.

Die Herstellung des Substrats (1) einerseits und der thermoelektrischen Elemente (4, 5) andererseits erfolgt in unabhängigen Prozessen. Zunächst wird auf dem Trägermaterial (10) des Substrats (1) vollflächig eine Schicht (17), insbesondere aus Kupfer, aufgebracht. Durch Abtragen der Schicht (17) aus Kupfer entlang dem vorgesehenen Verlauf der Stege (9, 11) wird die erforderliche Oberflächenstruktur des Substrats (1) mit mehreren elektrisch und thermisch leitfähigen Bereichen (2 a - f) erzeugt, die die isolierenden Bereiche entlang der Stege (9, 11) voneinander trennen. Die Stege bestehen aus dem Trägermaterial (10), insbesondere aus Kunststoff.

Anschließend wird auf die jeweils in Richtung des Substrats (1) weisende Oberfläche jedes thermoelektrischen Elementes (4, 5) an der kalten Seite (12) die Haftschicht (13) und an der heißen Seite (15) die Haftschicht (16) aufgebracht, bevor die thermoelektrischen Elemente (4, 5) jeweils paarweise mit einem der Bereiche (2 a - e) sowie auf der heißen Seite mit dem Bereich (2 f) verklebt werden. Alternativ werden die Haftschichten (13,16) auf das Substrat (1) auf der kalten bzw. heißen Seite (12,15) aufgebracht, bevor die thermoelektrischen Elemente (4, 5) jeweils paarweise mit einem der Bereiche (2 a - e) sowie auf der heißen Seite mit dem Bereich (2 f) verklebt werden.

In einem letzten Schritt werden schließlich die elektrischen Leiter (14) auf der kalten Seite (12) zwischen benachbarten thermoelektrischen Elementen (4, 5) die durch einen Steg (11) voneinander getrennt sind, angebracht, insbesondere verklebt oder verlötet.

### Bezugszeichenliste

| **Nr.** | **Bezeichnung** | **Nr.** | **Bezeichnung** |
|---|---|---|---|
| 1 | Substrat | 21 | Kontaktierung |
| 2 a- f | Bereiche (thermisch u. elektrisch leitend) | 22 | Wärmefluss |
| 3 | Modul | 23 | Stromfluss |
| 4, 5 | thermoelektrische Elemente | 24 | Modul |
| 4 a | n-Schicht | 25, 26 | thermoelektrische Elemente |
| 4 b | p-Schicht | 25 a | n-Schicht |
| 5 a | n-Schicht | 25 b | p-Schicht |
| 5 b | p-Schicht | 26 a | n-Schicht |
| 6 | Grenzschicht | 26 b | p-Schicht |
| 7 a, b | Wärmequelle | 27 a - f | elektrisch leitende Bereiche |
| 8 a, b | Wärmesenke | 28 | Verbindungssubstrat |
| 9 | Steg (längs) | 29 | Vergussmasse |
| 10 | Trägermaterial | 30 | Gehäuse |
| 11 | Stege | | |
| 12 | kalte Seite | | |
| 13 | Haftschicht (thermisch u. elektrisch leitend) | | |
| 14 | elektrischer Leiter | | |
| 15 | heiße Seite | | |
| 16 | Haftschicht (thermisch leitend) | | |
| 17 | Schicht | | |
| 18, 19 | Schnittlinien | | |
| 20 | Stromfluss | | |

## Patentansprüche

1. Modul umfassend mehrere elektrisch in Serie geschaltete thermoelektrische Elemente, die jeweils aus mindestens einer n-Schicht und mindestens einer p-Schicht aus thermoelektrischem Material unter Ausbildung wenigstens eines sich entlang einer Grenzschicht ausbildenden pn-Übergangs bestehen, wobei ein Temperaturgradient parallel zur Grenzschicht zwischen einer heißen und einer kalten Seite jedes thermoelektrischen Elementes anlegbar bzw. abgreifbar ist, **dadurch gekennzeichnet, dass**
- das Modul (3,24) ein Substrat (1) mit mehreren elektrisch und thermisch leitfähigen Bereichen (2) aufweist, die isolierende Bereiche (9,11) thermisch und elektrisch voneinander trennen,
- jedes thermoelektrische Element (4,5,25,26) eine nach außen weisende p-Schicht (4b, 5b, 25b, 26b) und eine an der gegenüberliegenden Seite nach außen weisende n-Schicht (4a, 5a, 25a, 26a) aufweist,
- eine nach außen weisende p-Schicht (4b, 5b, 25b, 26b) eines thermoelektrischen Elementes (4,5,25,26) stets mit nur einer nach außen weisenden n-Schicht (4a, 5a, 25a, 26a) eines benachbarten thermoelektrischen Elementes elektrisch leitend verbunden ist und
- jeweils zwei benachbarte thermoelektrische Elemente (4,5 bzw. 25,26) an deren kalter Seite (12) mittels einer thermisch und elektrisch leitenden Haftschicht (13) mit einem der elektrisch und thermisch leitfähigen Bereiche (2 a -e) des Substrats (1) elektrisch leitend verbunden sind.

2. Modul nach Anspruch 1, **dadurch gekennzeichnet, dass** jeweils zwei benachbarte thermoelektrische Elemente (4,5 bzw. 25,26), die mit voneinander getrennten elektrisch und thermisch leitfähigen Bereichen (2 a- e) des Substrats verbunden sind, an deren dem Substrat (1) abgewandten, nach außen weisenden p-Schicht (4b, 5b, 25b, 26b) bzw. n-Schicht (4a, 5a, 25a, 26a) mittels eines elektrischen Leiters (14, 27, 28) miteinander verbunden sind.

3. Modul nach Anspruch 1 oder 2, **dadurch gekennzeichnet, dass** benachbarte thermoelektrische Elemente (4,5 bzw. 25,26) an deren heißer Seite (15) mittels einer thermisch leitenden und elektrisch isolierenden Haftschicht (16) mit mindestens einem der elektrisch und thermisch leitfähigen Bereiche (2f) des Substrats (1) verbunden sind.

4. Modul nach einem der Ansprüche 1 bis 3, **dadurch gekennzeichnet, dass** die nach außen weisenden p- bzw. n-Schichten (4b, 5b, 25b, 26b, 4a, 5a, 25a, 26a)die elektrisch und thermisch leitfähigen Bereiche (2a -f) nur teilweise überdecken.

5. Modul nach einem der Ansprüche 1 bis 4, **dadurch gekennzeichnet, dass** die elektrisch und thermisch leitfähigen Bereiche (2 a- e) auf der kalten Seite (12) thermisch leitend mit mindestens einer Wärmesenke (8) verbunden sind.

6. Modul nach einem der Ansprüche 1 bis 5, **dadurch gekennzeichnet, dass** die elektrisch und thermisch leitfähigen Bereiche (2f) auf der heißen Seite (15) thermisch leitend mit mindestens einer Wärmequelle (7) verbunden sind.

7. Modul nach einem der Ansprüche 1 bis 6, **dadurch gekennzeichnet, dass** das Substrat (1) aus einem flexiblen bahnförmigen Trägermaterial besteht.

8. Modul nach Anspruch 7, **dadurch gekennzeichnet, dass** die elektrisch und thermisch leitfähigen Bereiche (2 a - e) durch mindestens einen längs und mehrere quer zu dem bahnförmigen Trägermaterial (10) verlaufende isolierende Stege (9, 11) elektrisch voneinander getrennt sind.

9. Modul nach einem der Ansprüche 2 bis 8, **dadurch gekennzeichnet, dass** jeweils zwei benachbarte thermoelektrische Elemente (4, 5, 25, 26) die mit voneinander getrennten elektrisch und thermisch leitfähigen Bereichen (2a - 2e) des Substrats (1) verbunden sind, an deren dem Substrat (1) abgewandten, nach außen weisenden p-Schicht bzw. n-Schicht mittels elektrisch leitender Bereiche eines VerbindungsSubstrates (28) miteinander verbunden sind.

## Claims

1. Module comprising a plurality of series-connected thermoelectric elements, each consisting of at least one n-layer and at least one p-layer of thermoelectric material to form at least one pn junction formed along a boundary layer, wherein a temperature gradient can be applied or tapped between a hot and a cold side of each thermoelectric element, **characterized in that**
- the module (3, 24) comprises a substrate (1) having a plurality of electrically and thermally conductive areas (2) which separate insulating areas (9, 11) thermally and electrically from one another,
- each thermoelectric element (4, 5, 25, 26) has an outwardly facing p-layer (4b, 5b, 25b, 26b) and an outwardly facing n-layer (4a, 5a, 25a, 26a) on the opposite side,
- an outwardly facing p-layer (4b, 5b, 25b, 26b) of a thermoelectric element (4, 5, 25, 26) is always connected in an electrically conducting manner to only one outwardly facing n-layer (4a, 5a, 25a, 26a) of an adjacent thermoelectric element and
- respectively two adjacent thermoelectric elements (4, 5 or 25, 26) on the cold side (12) thereof are connected in an electrically conducting manner by means of a thermally and electrically conducting adhesive layer (13) to one of the electrically and thermally conductive areas (2a-e) of the substrate (1).

2. The module according to claim 1, **characterized in that** respectively two adjacent thermoelectric elements (4, 5 or 25, 26) which are connected to separate electrically and thermally conductive areas (2a-e) of the substrate are connected to one another by means of an electrical conductor (14, 27, 28) on the outwardly facing p-layer (4b, 5b, 25b, 26b) or n-layer (4a, 5a, 25a, 26a) thereof, facing away from the substrate (1).

3. The module according to claim 1 or 2, **characterized in that** adjacent thermoelectric elements (4, 5 or 25, 26) are connected on the hot side (15) thereof by means of a thermally conductive and electrically insulating adhesive layer (16) to at least one of the electrically and thermally conductive areas (2f) of the substrate (1).

4. The module according to any one of claims 1 to 3, **characterized in that** the outwardly facing p- or n-layers (4b, 5b, 25b, 26b, 4a, 5a, 25a, 26a) only partially overlap the electrically and thermally conductive areas (2a-f).

5. The module according to any one of claims 1 to 4, **characterized in that** the electrically and thermally conductive areas (2a-e) are connected on the cold side (12) in a thermally conductive manner to at least one heat sink (8).

6. The module according to any one of claims 1 to 5, **characterized in that** the electrically and thermally conductive areas (2f) are connected on the hot side (15) in a thermally conductive manner to at least one heat source (7).

7. The module according to any one of claims 1 to 6, **characterized in that** the substrate (1) consists of a flexible web-shaped carrier material.

8. The module according to claim 7, **characterized in that** the electrically and thermally conductive areas (2a-e) are separated electrically from one another by at least one insulating web running longitudinally and a plurality of insulating webs (9, 11) running transversely to the web-shaped carrier material (10).

9. The module according to any one of claims 2 to 8, **characterized in that** respectively two adjacent thermoelectric elements (4, 5, 25, 26) which are connected to separate electrically and thermally conductive areas (2a-2e) of the substrate (1) are connected to one another at the outwardly facing p-layer or n-layer, facing away from the substrate (1) by means of electrically conductive areas of a connecting substrate (28).

## Revendications

1. Module comprenant plusieurs éléments thermoélectriques montés en série, qui consistent chacun dans au moins une couche N et au moins une couche P en matière thermoélectrique sous formations d'au moins un passage PN se créant le long d'une couche de délimitation, un gradient de température étant applicable sur ou prélevable à la parallèle de la couche de délimitation, entre un côté chaud et un côté froid de chaque élément thermoélectrique, **caractérisé en ce que**
- le module (3, 24) comporte un substrat (1) avec plusieurs zones (2) électriquement et thermiquement conductrices, qui séparent électriquement et thermiquement l'une de l'autre des zones isolantes (9, 11),
- chaque élément thermoélectrique (4, 5, 25, 26) comporte une couche P (4b, 5b, 25b, 26b) dirigée vers l'extérieur et une couche N (4a, 5a, 25a, 26a) dirigée vers l'extérieur, sur le côté opposé,
- une couche P (4b, 5b, 25b, 26b) dirigée vers l'extérieur d'un élément thermoélectrique (4, 5, 25, 26) est toujours reliée en étant conductrice d'électricité avec une seule couche N (4a, 5a, 25a, 26a) dirigée vers l'extérieur d'un élément thermoélectrique voisin et
- chaque fois deux éléments thermoélectriques (4, 5 ou 25, 26) voisins sont reliés en étant conducteurs d'électricité sur leur côté froid (12) au moyen d'une couche adhérente (13) thermiquement et électriquement conductrice avec l'une des zones (2a à e) électriquement et thermiquement conductibles du substrat (1).

2. Module selon la revendication 1, **caractérisé en ce que** chaque fois deux éléments thermoélectriques (4, 5 ou. 25, 26) voisins, qui sont reliés avec des zones (2a à e) thermiquement et électroniquement conductibles séparées les unes des autres du substrat sont reliés entre eux sur leur couche P (4b, 5b, 25b, 26b) ou sur leur couche N (4a, 5a, 25a, 26a) opposée au substrat (1) au moyen d'un conducteur électrique (14, 27, 28).

3. Module selon la revendication 1 ou la revendication 2, **caractérisé en ce que** des éléments thermoélectriques (4, 5 ou 25, 26) voisins sont reliés sur leur couche chaude (15) au moyen d'une couche adhérente (16) thermiquement conductrice et électriquement isolante avec au moins l'une des zones (2f) électriquement et thermiquement conductibles du substrat (1).

4. Module selon l'une quelconque des revendications 1 à 3, **caractérisé en ce que** les couches P ou N (4b, 5b, 25b, 26b, 4a, 5a, 25a, 26a) dirigées vers l'extérieur ne recouvrent que partiellement les zones (2a à f) électriquement et thermiquement conductibles.

5. Module selon l'une quelconque des revendications 1 à 4, **caractérisé en ce que** sur le côté froid (12), les zones (2a à e) électriquement et thermiquement conductibles sont reliées en étant thermiquement conductrices avec au moins avec un dissipateur thermique (8).

6. Module selon l'une quelconque des revendications 1 à 5, **caractérisé en ce que** sur le côté chaud (15), les zones (2f) électriquement et thermiquement conductibles sont reliées en étant thermiquement conductrices avec au moins une source de chaleur thermique (7).

7. Module selon l'une quelconque des revendications 1 à 6, **caractérisé en ce que** le substrat (1) consiste dans une matière porteuse flexible en forme de bande.

8. Module selon la revendication 7, **caractérisé en ce que** les zones (2a à e) électriquement et thermiquement conductibles sont électriquement isolées les unes des autres par au moins une barrette isolante s'étendant à la longitudinale et plusieurs barrettes isolantes (9, 11) s'étendant à la transversale de la matière porteuse (10) en forme de bande.

9. Module selon l'une quelconque des revendications 2 à 8, **caractérisé en ce que** chaque fois deux éléments thermoélectriques (4, 5, 25, 26) voisins qui sont reliés avec des zones (2a à 2e) du substrat (1) électriquement et thermiquement conductibles séparées l'une de l'autre du substrat sont reliés l'un à l'autre sur leur couche P ou sur leur couche N dirigée vers l'extérieur, opposée au substrat (1) au moyen de zones électriquement conductrices d'un substrat de liaison (28).
